# EUROPÄISCHE PATENTSCHRIFT

(11) **EP 0 748 520 B1**
(45) Veröffentlichungstag und Bekanntmachung des Hinweises auf die Patenterteilung: **16.12.1998**
(21) Anmeldenummer: 95911267.3
(22) Anmeldetag: 24.02.1995
(51) Int. Cl.: H01L 29/10, H01L 29/24, H01L 29/78, H01L 29/739, H01L 21/04

(54) **MIS-STRUKTUR AUF SILICIUMCARBID-BASIS MIT HOHER LATCH-UP-FESTIGKEIT**
SILICON CARBIDE-BASED MIS STRUCTURE WITH HIGH LATCH-UP RESISTANCE
STRUCTURE MIS A BASE DE CARBURE DE SILICIUM A RESISTANCE ELEVEE AU VERROUILLAGE

(30) Priorität: 04.03.1994 EP 94103325
(43) Veröffentlichungstag der Anmeldung: 18.12.1996
(73) Patentinhaber: SIEMENS AKTIENGESELLSCHAFT, 80333 München (DE)
(72) Erfinder: MITLEHNER, Heinz, D-91080 Uttenreuth (DE); STEPHANI, Dietrich, D-91088 Bubenreuth (DE); TIHANYI, Jenö, D-85551 Kirchheim (DE)
(86) Internationale Anmeldenummer: EP9500679
(87) Internationale Veröffentlichungsnummer: WO9524055

(56) Entgegenhaltungen:
- EP-A- 0 296 997
- EP-A- 0 481 153
- FR-A- 2 559 958
- US-A- 5 124 779
- US-A- 5 170 231
- PATENT ABSTRACTS OF JAPAN Bd. 17, Nr. 6 (E-1302) 07 Januar 1993 & JP,A,04 239 778 (FUJI ELECTRIC CO LTD) 27 August 1992
- PROCEEDINGS OF THE 3RD INTERNATIONAL SYMPOSIUM ON POWER SEMICONDUCTOR DEVICES AND ICS ISPSD 91, Seite 195 A. PREUSSGER 'STP - A NEW SMART POWER TECHNOLOGY WITH A FULLY SELF ALIGNED DMOS CELL'
- PATENT ABSTRACTS OF JAPAN Bd. 15, Nr. 165 (E-1061) 25 April 1991 & JP,A,03 034 573 (SHARP CORP) 14 Februar 1991
- PROCEEDINGS OF THE 3RD INTERNATIONAL SYMPOSIUM ON POWER SEMICONDUCTOR DEVICES AND ICS ISPSD 91, Seite 211 S. ERCNEN ET AL 'THE VERTICAL IGBT WITH AN IMPLANTED BURIED LAYER'
- PATENT ABSTRACTS OF JAPAN Bd. 17, Nr. 356 (E-1394) 06 Juli 1993 & JP,A,05 055 583 (SANYO ELECTRIC CO LTD) 05 M rz 1993
- PATENT ABSTRACTS OF JAPAN Bd. 10, Nr. 42 (E-382) 19 Februar 1986 & JP,A,60 196 975 (NISSAN JIDOSHA KK) 05 Oktober 1985
- PATENT ABSTRACTS OF JAPAN Bd. 10, Nr. 158 (E-409) 06 Juni 1986 & JP,A,61 013 667 (TOSHIBA K.K.) 21 Januar 1986
- PATENT ABSTRACTS OF JAPAN Bd. 12, Nr. 375 (E-666) 07 Oktober 1988 & JP,A,63 122 277 (FUJI ELECTRIC CO LTD) 26 Mai 1988

## Beschreibung

Die Erfindung betrifft eine MIS-Struktur.

MIS (Metal-Insulator-Semiconductor)-Strukturen bilden die Grundlage für eine Reihe wichtiger Halbleiterbauelemente. Charakteristisch für MIS-Strukturen ist eine über eine Isolatorschicht elektrisch isoliert auf einer Oberfläche eines Halbleiters angeordnete Gateelektrode, an die ein elektrisches Feld angelegt wird zum Steuern des elektrischen Widerstandes eines unterhalb der Gateelektrode liegenden, oberflächennahen Bereichs des Halbleiters (Kanal). Derartige Strukturen werden deshalb oft auch als IG (Insulated Gate)-Strukturen bezeichnet. Der Kanalbereich verbindet zwei weitere, entgegengesetzt zum Kanalbereich dotierte Gebiete des Halbleiters. Eine Gatespannung mit einer dem Leitungstyp des Kanalbereichs entsprechenden Polung, d.h. negativ bei n-Dotierung und positiv bei p-Dotierung, erzeugt eine elektrisch leitfähige Inversionsschicht in dem Kanalbereich. Die Steuerbarkeit des Kanalbereichs einer solchen MIS-Struktur ist abhängig von der angelegten Gatespannung, der Dotierstoffkonzentration im Kanalbereich und auch von der Dicke der Isolatorschicht. Im allgemeinen ist bei einer MIS-Struktur ein als Driftgebiet bezeichnetes erstes Halbleitergebiet vorgesehen, an dessen Oberfläche ein als Basis bezeichnetes zweites Halbleitergebiet eindiffundiert (DMOS-Technik) oder implantiert ist. In diese Basis ist ein drittes Halbleitergebiet eindiffundiert oder implantiert, das als Source bezeichnet wird. Source und Driftgebiet werden vom gleichen Leitungstyp gewählt, üblicherweise dem n-Leitungstyp wegen der höheren Beweglichkeit der Elektronen gegenüber den Löchern. Die Source wird im allgemeinen deutlich höher dotiert wird als das Driftgebiet. Die Basis wird dagegen vom anderen Leitungstyp, also üblicherweise vom p-Leitungstyp, gewählt.

Ein Source- und Driftgebiet verbindender oberflächennaher Bereich der Basis bildet das Kanalgebiet. Im allgemeinen sind in einem Bereich außerhalb des Kanalgebiets die Basis und die Source über eine Sourceelektrode elektrisch kurzgeschlossen, d.h. auf gleiches Potential gelegt. Das Driftgebiet ist im allgemeinen beispielsweise durch epitaktisches Abscheiden auf einem Halbleitersubstrat angeordnet.

Derartige MIS-Strukturen können zu einem MISFET (Metal-Insulator-Semiconductor-Field-Effect-Transistor) oder auch einem IGBT (Insulated-Gate-Bipolar-Transistor) weitergebildet werden, indem ein weiteres, in der Regel hoch dotiertes Halbleitergebiet vorgesehen wird, das als Draingebiet oder kurz Drain bezeichnet wird und mit einer Drainelektrode kontaktiert wird. Zwischen Source und Drain wird die Betriebsspannung des Bauelements angelegt. Das Draingebiet kann entweder an der gleichen Oberfläche des Driftgebiets ausgebildet sein wie die Source (lateraler Aufbau) oder an der entgegengesetzten Seite des Driftgebietes oder des Halbleitersubstrats (vertikaler Aufbau). Ein vertikaler Aufbau ist insbesondere für die Leistungselektronik mit hohen Strömen und hohen Spannungen geeignet, weil das gesamte Volumen des Driftgebietes und gegebenenfalls des Halbleitersubstrats und nicht nur ein oberflächennaher lateraler Bereich des Driftgebietes für den Stromtransport und den Spannungsabfall zur Verfügung steht. Wählt man das Draingebiet vom gleichen Leitungstyp wie das Driftgebiet, also üblicherweise vom n-Leitungstyp, so erhält man einen MISFET. Wählt man hingegen das Draingebiet vom entgegengesetzten Leitungstyp wie das Driftgebiet, so erhält man wegen des zusätzlichen p-n-Übergangs zwischen Draingebiet und Driftgebiet ein bipolares Bauelement, den IGBT (Insulated-Gate-Bipolar-Transistor). Die Source wird hier im Sprachgebrauch auch Emitter und die Drain auch Kollektor des bipolaren Transistors genannt.

MIS-Strukturen und damit geformte Bauelemente sind im allgemeinen mit Silicium (Si) als Halbleitermaterial und Siliciciumdioxid (SiO₂) für die Isolatorschicht gebildet und werden dann auch als MOS (Metal-Oxide-Semiconductor)-Strukturen bezeichnet. Es sind jedoch auch MIS-Strukturen mit anderen Halbleitermaterialien und anderen Isolatormaterialien bekannt.

Ein in Siliciumcarbid (SiC) als Halbleitermaterial gebildeter lateraler MOSFET umfaßt ein durch Ionenimplantation an der Oberfläche eines SiC-Substrats gebildetes Sourcegebiet und ein an derselben Oberfläche lateral zum Sourcegebiet versetztes Draingebiet, das ebenfalls durch Ionenimplantation im SiC-Substrat gebildet ist. Eine Basis ist jedoch nicht vorgesehen. Vielmehr ist das SiC-Substrat selbst entgegengesetzt zu Source und Drain dotiert. Der zwischen Source und Drain angeordnete Kanalbereich ist mit dem SiC-Substrat gebildet und von einer über eine Isolatorschicht aus Siliciumdioxid elektrisch vom SiC-Substrat isolierten Gateelektrode steuerbar. Source- und Draingebiet sind jeweils über eine Source-bzw. eine Drainelektrode kontaktiert (*WO 89/04056).*

Ein weiterer lateraler SiC-MOS-FET umfaßt eine erste, auf einem Siliciumsubstrat epitaktisch aufgewachsene, n-leitende β-SiC-Schicht, eine zweite, mit Bor p-dotierte SiC-Schicht, die epitaktisch auf der ersten SiC-Schicht aufgewachsen ist und ein Sourcegebiet und ein Draingebiet, die jeweils durch Ionenimplantation von Stickstoff in die zweite SiC-Schicht erzeugt sind und damit n-dotiert sind. Auf der p-dotierten, zweiten SiC-Schicht ist zwischen Source und Drain eine Oxidschicht und darauf eine Gateelektrode angeordnet *(Patent Abstract of Japan, Vol. 15, No. 165 (E-1061), 25. April 1991* & *JP-A-03-034 573*).

Ein bekannter vertikaler SiC-Trench-MOSFET umfaßt eine erste n-leitende SiC-Epitaxieschicht auf einem n-leitenden Substrat, eine auf der n-leitenden SiC-Schicht angeordnete zweite, p-leitende SiC-Epitaxieschicht, ein in der Oberfläche dieser zweiten, p-leitenden SiC-Schicht ionenimplantiertes und n-leitendes Sourcegebiet. Durch das n-leitende Sourcegebiet und die zweite, p-leitende SiC-Schicht ist ein Graben (Trench) geätzt, der bis hinunter zur ersten SiC-Schicht reicht. Der Graben ist mit einer Oxidschicht überzogen und danach mit einem Gatematerial gefüllt. Auf der vom Gate abgewandten Seite des n-leitenden Substrats ist eine Drainelektrode angeordnet. Die zweite, p-leitende SiC-Schicht ist als Basisgebiet vorgesehen *(Patent Abstracts of Japan, Vol. 17, No. 6 (E-1302), 7. Januar 1993* & *JP-A-04-239 778).*

Ein gleich aufgebauter vertikaler Trench-MOSFET auf SiC-Basis ist aus US *5,170,231* bekannt. Bei diesem weiteren bekannten SiC-Trench-MOSFET ist die als Basisgebiet vorgesehene zweite SiC-Epitaxieschicht während des epitaktischen Wachstums mit Aluminium dotiert. Das n-leitende Substrat besteht aus SiC.

MIS-Strukturen mit eindiffundierter Basis und darin eindiffundierter Source sind in SiC praktisch nicht zu verwirklichen, weil Diffusionsprozesse in SiC nicht oder nur schwer möglich sind.

Beim Design von MIS-Strukturen sind eine Vielzahl von unterschiedlichen technologischen und physikalischen Randbedingungen zu beachten, die einander beeinflussen können. Solche Randbedingungen sind insbesondere eine möglichst niedrig einstellbare Durchlaßspannung zwischen Source und Drain, d.h. ein möglichst kleiner Widerstand des stromführenden Kanalgebiets im Durchlaßfall, eine möglichst niedrig einstellbare Schwellspannung an der Gateelektrode zum Aufsteuern des Kanalgebiets und die Unterdrückung parasitärer bipolarer Effekte, die durch Minoritätsträger verursacht werden. Im Falle eines Einsatzes der MIS-Struktur bei hohen Spannungen sollte die MIS-Struktur zudem eine hohe Durchbruchfestigkeit im Sperrfall aufweisen.

Ein besonderes Problem ist der sogenannte Latch-up-Effekt, der zu den parasitären bipolaren Effekten gehört. Ein Latch-up kann bei zu hohen Strömen im Durchlaßbetrieb (statisches Latch-up) oder beim An- und Abschalten der Source-Drain-Spannung (dynamisches Latch-up) auftreten, wenn der von Source-, Basis- und Driftgebiet in der MIS-Struktur gebildete n-p-n-oder p-n-p-Transistor aufgesteuert wird und die Steuerbarkeit des Stromes im Kanalbereich durch die Gatespannung dadurch teilweise oder ganz verloren geht. Es wird dabei ein Strom bzw. beim An- oder Abschalten ein Verschiebestrom von Ladungsträgern vom p-n-Übergang zwischen Driftgebiet und Basis zur mit der Basis kontaktierten Sourceelectrode erzeugt. Dabei müssen diese Ladungsträger den elektrischen Bahnwiderstand in der Basis überwinden, der am größten ist für Ladungsträger, die durch einen Bereich der Basis unterhalb des gesamten Sourcegebietes hindurchwandern. Damit ist auch der Spannungsabfall ΔU = R·I, der gleich dem Produkt aus lateralem Bahnwiderstand R und dem Strom I der Ladungsträger ist, für diese Ladungsträger am größten. Um ein Latch-up zu vermeiden, muß dieser Spannungsabfall ΔU kleiner sein als die Barrierenspannung (Built-in-Spannung) des p-n-Übergangs zwischen Source und Basis.

Zur Vermeidung des Latch-up-Effekts ist bei MIS-Strukturen auf Siliciumbasis bekannt, das p-dotierte Basisgebiet in einem Teilgebiet unterhalb des n-dotierten Sourcegebietes stärker zu dotieren. Damit wird der laterale Bahnwiderstand in diesem p⁺-dotierten Teilgebiet des Basisgebietes herabgesetzt. Beim Herstellen dieses höher dotierten Teilgebietes der Basis sollte vermieden werden, daß auch das Kanalgebiet der Basis höher dotiert wird, um die Schwellspannung (threshold voltage) am Gate nicht zu erhöhen.

Bei aus *DE-C-27 03 877, EP-A-0 481 153* oder *Patent Abstracts of Japan, Vol. 10, No. 42 (E-382), 19. Februar 1986 & JP-A-60-196 975* bekannten vertikalen Silicium-MOSFETs sowie einem aus *B.J. Baliga, "Modern Power Devices", 1987, John Wiley + Sons, New York,* Seiten 368 bis 371 bekannten vertikalen Silicium-IGBT erstreckt sich das höherdotierte p⁺-Teilgebiet der Basis nur unter einem Teil der Source. Bei den beiden MOSFETs ist das p⁺-Teilgebiet durch Ionenimplantation erzeugt, bei dem zuletzt genannten IGBT dagegen durch Diffusion. An einer vom Kanalgebiet der Basis abgewandten Seite sind das Sourcegebiet und das höherdotierte p⁺-Teilgebiet der Basis über eine Source-Elektrode jeweils kurzgeschlossen. Bei dem aus der *DE-C-27 03 877* bekannten Silicium-MOSFET ist ferner das Basisgebiet in einem Übergangsbereich zum Driftgebiet höher dotiert. Der Übergangsbereich umgibt das Sourcegebiet wannenförmig und tritt unter einem Winkel an die Oberfläche des Driftgebietes.

Es sind auch in Silicium gebildete vertikale MOSFETs *(FR-A-2 559 958, Patent Abstracts of Japan, Vol. 12, No. 375 (E-666),* 7. *Oktober 1988 & JP-A-63 122 277, Proceedings of the 3rd International Symposium on Power Semiconductor Devices and ICS ISPSD '91, Seiten 195 bis 197)* und vertikale IGBTs *(Patent Abstracts of Japan, Vol. 17, No. 356 (E-1394), 6. Juli 1993 & JP-A-05 055 583, Proceedings of the 3rd International Symposium on Power Semiconductor Devices and ICs ISPSD '91, Seiten 211 bis 214)* bekannt, bei denen sich das durch Ionenimplantation von Bor höherdotierte p⁺-Teilgebiet der p-Basis unterhalb des gesamten Sourcegebietes erstreckt.

Aus *Patent Abstracts of Japan, Vol. 10, No. 158 (E-409), 6. Juni 1986,* ist ferner ein vertikaler, ebenfalls in Silicium gebildeter MOSFET bekannt, bei dem ein p-Basisgebiet in einem Übergangsgebiet zu einem n-dotierten Driftgebiet höher dotiert ist. Durch das hoher dotierte p⁺-Übergangsgebiet der Basis wird die Durchbruchfestigkeit des MOSFET erhöht.

Der Erfindung liegt nun die Aufgabe zugrunde, eine MIS-Struktur anzugeben mit
(i) einer niedrigen statischen und dynamischen Verlustleistung im Nennbetrieb
(ii) Eignung für Sperrspannungen von wenigstens etwa 200 V bis mindestens etwa 5000 V
(iii) einer hohen Latch-up-Festigkeit und
(iv) einer hohen Robustheit auch bei Temperaturen von 200°C und mehr, insbesondere bezüglich der Durchlaßund Sperreigenschafen im Kanalgebiet.

Diese Aufgabe wird gemäß der Erfindung gelöst mit den Merkmalen des Anspruchs 1. In einem Basisgebiet eines Leitungstyps an oder in einer Oberfläche eines Driftgebietes des entgegengesetzten Leitungstyps ist ein Sourcegebiet vom gleichen Leitungstyp wie das Driftgebiet angeordnet. Das Basisgebiet weist in einem wenigstens teilweise unterhalb des Sourcegebietes liegenden und unmittelbar an das Sourcegebiet angrenzenden Teilgebiet eine höhere Ladungsträgerkonzentration auf als in einem zwischen Sourcegebiet und Driftgebiet liegenden Kanalgebiet, dem eine Isolatorschicht und eine darauf angeordnete Gateelektrode zum Steuern des Widerstandes des Kanalgebietes zugeordnet sind. Das Driftgebiet, das Basisgebiet und das Sourcegebiet sind jeweils mit dem Halbleitermaterial Siliciumcarbid (SiC) gebildet.

Durch die Verwendung von Siliciumcarbid als Halbleiter für die MIS-Struktur erreicht man eine deutliche Verringerung der Verlustleistung im Nennbetrieb im Vergleich zu Silicium (Teilaufgabe (i)), eine höhere Sperrfähigkeit bei gleichem Volumen als bei Silicium (Teilaufgabe (ii)) sowie eine hohe Robustheit und Betriebssicherheit auch bei hohen Temperaturen von mehr als 200°C, bei denen vergleichbare Silicium-MIS-Strukturen nicht mehr funktionsfähig sind (Teilaufgabe (iv)).

Das höher dotierte Teilgebiet des Basisgebietes unter dem Sourcegebiet gewährleistet die hohe Latch-up-Festigkeit (Teilaufgabe (iii)).

Vorteilhafte Ausgestaltungen und Weiterbildungen der MIS-Struktur gemäß der Erfindung ergeben sich aus den vom Anspruch 1 abhängigen Ansprüchen.

Die Erfindung wird im folgenden anhand von Ausführungsbeispielen näher erläutert. Dabei wird auf die Zeichnung Bezug genommen, in deren
- FIG.1: eine planare MIS-Struktur mit einem sich unterhalb eines ionenimplantierten n⁺-Sourcegebiets erstreckenden ionenimplantierten p⁺-Teilgebiet eines in einem n-Driftgebiet ionenimplantierten p-Basisgebietes,
- FIG.2: eine solche MIS-Struktur mit einem p⁺-dotierten, an das n-Driftgebiet angrenzenden Übergangsgebiet des Basisgebietes,
- FIG.3: Dotierprofile für eine durch dreifache Ionenimplantation hergestellte MIS-Struktur,
- FIG.4: eine MIS-Struktur mit einer epitaktisch aufgewachsenen p-Schicht als Basisgebiet,
- FIG.5: eine als MISFET oder IGBT weitergebildete MIS-Struktur und
- FIG.6: eine Trench-MIS-Struktur
jeweils schematisch dargestellt sind. Einander entsprechende Teile der MIS-Strukturen sind mit denselben Bezugszeichen versehen.

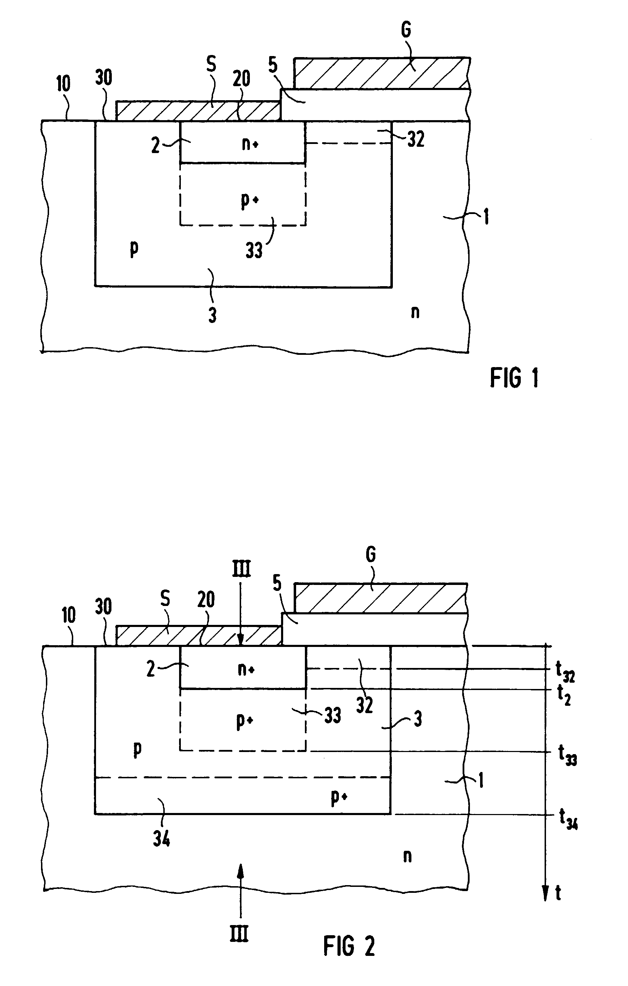

In FIG. 1 sind ein Driftgebiet mit 1, eine Oberfläche des Driftgebietes mit 10, ein Sourcegebiet mit 2, eine Oberfläche des Sourcegebietes 2 mit 20, ein Basisgebiet mit 3, eine Oberfläche des Basisgebietes 3 mit 30, ein Kanalgebiet des Basisgebietes 3 mit 32, ein Teilgebiet des Basisgebietes 3 mit 33, ein Isolatorgebiet mit 5, eine Gateelektrode mit G und eine Sourceelektrode mit S bezeichnet. Das Driftgebiet 1 ist ein n-leitendes Halbleitergebiet aus Siliciumcarbid (SiC), vorzugsweise eine epitaktisch aufgewachsene SiC-Schicht, die beispielsweise mit Stickstoff (N) dotiert sein kann. Das Basisgebiet 3 mitsamt seinen beiden zugehörigen Gebieten, dem Kanalgebiet 32 und dem Teilgebiet 33, ist ein p-leitendes Halbleitergebiet aus SiC. Das Sourcegebiet 2 ist ein n-leitendes Halbleitergebiet aus SiC mit einer vorzugsweise höheren Ladungsträgerkonzentration (n⁺) als das Driftgebiet 1. Das p-Basisgebiet 3 ist in der Oberfläche 10 des Driftgebietes 1 angeordnet und vorzugsweise durch Ionenimplantation von Dotierstoffatomen als Akzeptoren in das Driftgebiet 1 erzeugt. Das n⁺-Sourcegebiet 2 ist vorzugsweise durch Ionenimplantation von Dotierstoffatomen als Donatoren in dem Basisgebiet 3 erzeugt und ist von dem Driftgebiet 1 durch das Basisgebiet 3 vollständig getrennt. Über dem an der Oberfläche 30 des Basisgebietes 3 angeordneten Kanalgebiet 32 ist das Isolatorgebiet 5 angeordnet, das sich vorzugsweise auch über einen Teil der Oberfläche 20 des Sourcegebietes 2 erstreckt. Auf dem Isolatorgebiet 5 ist die Gateelektrode G angeordnet, die zum Steuern des elektrischen Widerstandes des Kanalgebietes 32 vorgesehen ist. Die Sourceelektrode S ist auf wenigstens einem Teil der nicht von dem Isolatorgebiet 5 bedeckten, freien Oberfläche 20 des Sourcegebietes 2 und auf wenigstens einem freiliegenden Teil der angrenzenden Oberfläche 30 des Basisgebietes 3 angeordnet. Durch die Sourceelektrode S sind das Sourcegebiet 2 und das Basisgebiet 3 somit elektrisch kurzgeschlossen.

In einem von der Oberfläche 20 des Sourcegebietes 2 aus gesehen unterhalb des gesamten Sourcegebietes 2 sich erstreckenden und direkt an das Sourcegebiet 2 angrenzenden Teilgebiet 33 ist das Basisgebiet 3 nun mit einer höheren Ladungsträgerkonzentration (p⁺) ausgebildet als zumindestens in seinem Kanalgebiet 32. Dies wird vorzugsweise durch eine Ionenimplantation von zusätzlichen Dotierstoffatomen (Akzeptoren) in dieses Teilgebiet 33 des Basisgebietes 3 unterhalb des Sourcegebietes 2 erreicht. Die Eindringtiefe der Ionen wird dabei durch eine geeignete Wahl der Ionenenergie so eingestellt, daß die Mehrzahl der Ionen in das Teilgebiet 33 gelangt und dort als Akzeptoren die Ladungsträgerkonzentration der Löcher erhöht. In der dargestellten Ausführungsform einer MIS-Struktur kann für die beiden Ionenimplantationen zum Erzeugen des p⁺-Teilgebietes 33 bzw. des n⁺-Sourcegebietes 2 jeweils dieselbe Maske zum Abdecken des außerhalb der Oberfläche 20 liegenden Oberflächenbereichs verwendet werden.

Durch das vorzugsweise implantierte p⁺-Teilgebiet 33 unter dem Sourcegebiet 2 ist der Bahnwiderstand des Basisgebietes 3 in diesem kritischen Bereich verringert. Damit wird eine höhere Latch-up-Festigkeit der MIS-Struktur erreicht. Die Dotierstoffkonzentration (= Dotierung) im p⁺-Teilgebiet 33 wird abhängig vom Halbleitermaterial und der Dotierung des Sourcegebietes 2 und der daraus resultierenden Built-in-Spannung des p-n-Übergangs zwischen Sourcegebiet 2 und Basisgebiet 3 sowie weiter abhängig von einer an dem p-n-Übergang zwischen Basisgebiet 3 und Driftgebiet 1 im Sperrfall der MIS-Struktur anliegenden Spannung gewählt und ist vorzugsweise kleiner als die Dotierung des Sourcegebietes 2. Das Teilgebiet 33 kann auch mit seiner vom Sourcegebiet 2 abgewandten Seite direkt an das Driftgebiet 1 angrenzen.

In der FIG. 2 ist eine vorteilhafte Weiterbildung der Ausführungsform einer MIS-Struktur gemäß FIG. 1 dargestellt. Neben dem p⁺-Teilgebiet 33 unterhalb des Sourcegebietes 2 weist das Basisgebiet 3 ein weiteres, höher dotiertes Teilgebiet auf, das unmittelbar an das Driftgebiet 1 angrenzt und als Übergangsgebiet 34 bezeichnet ist. In dem Übergangsgebiet 34 ist das Basisgebiet 3 stärker p-leitend (p⁺) als in seinem Kanalgebiet 32 und vorzugsweise schwächer p-leitend als in seinem Teilgebiet 33. Die höhere Ladungsträgerkonzentration des Basisgebietes 3 im Übergangsgebiet 34 gewährleistet eine hohe Durchbruchs festigkeit an dem p-n-Übergang zwischen dem Übergangsgebiet 34 und dem Driftgebiet 1. Die p⁺-Dotierung des Übergangsgebietes 34 wird vorzugsweise durch eine tiefe Ionenimplantation von Akzeptorionen mit entsprechend hoher Energie in die Oberfläche 30 des Basisgebietes 3 erzeugt. Das Übergangsgebiet 34 kann bei einer geeignet gewählten Maskentechnik beispielsweise mit in ihrer Dicke variablen, schrägen Masken auch zumindest an der vom Kanalgebiet 32 entfernten Seite des Basisgebietes 3 bis an die Oberfläche 30 des Basisgebietes 3 reichen.

In einer besonders vorteilhaften Ausführungsform ist die MIS-Struktur mittels dreier nacheinander erfolgender Ionenimplantationsschritte hergestellt. In einem ersten Implantationsschritt wird in einem die Oberfläche 30 des Basisgebietes 3 definierenden Teilbereich der Oberfläche 10 des Driftgebietes 1 das Basisgebiet 3 erzeugt. Durch ein geeignet eingestelltes Dotierprofil in Abhängigkeit von der Tiefe t von der Oberfläche 10 kann das Basisgebiet 3 vorzugsweise an seiner Oberfläche 30 zumindest in einem als Kanalgebiet 32 vorgesehenen Gebiet mit einer niedrigeren Dotierung ausgebildet werden als in seinem Übergangsgebiet 34 zum Driftgebiet 1. Nun wird in einem zweiten Implantationsschritt in einem die Oberfläche 20 des Sourcegebietes 2 definierenden Teilbereich der Oberfläche 30 des Basisgebietes 3 das Teilgebiet 33 erzeugt. Das Dotierprofil und die Energie der Ionen werden dabei so eingestellt, daß das Teilgebiet 33 höher dotiert ist als das Kanalgebiet 32. In demselben Oberflächenbereich wie beim zweiten Implantationsschritt wird schließlich ein einem dritten Implantationsschritt das Sourcegebiet 2 an der Oberfläche 20 erzeugt. Das Dotierprofil bei diesem dritten Implantationsschritt ist durch ein wegen der gewünschten hohen Dotierung des Sourcegebietes 2 hohes Maximum unmittelbar an der Oberfläche 20 geprägt und fällt zum darunterliegenden Teilgebiet 33 des Basisgebietes 3 hin ab. Die Dotierprofile des zweiten und des dritten Implantationsschrittes werden so aufeinander abgestimmt, daß das hoch dotierte Sourcegebiet 2 unmittelbar in das hoch dotierte Teilgebiet 33 übergeht.

Die Reihenfolge der drei Implantationsschritte kann natürlich auch beliebig vertauscht werden.

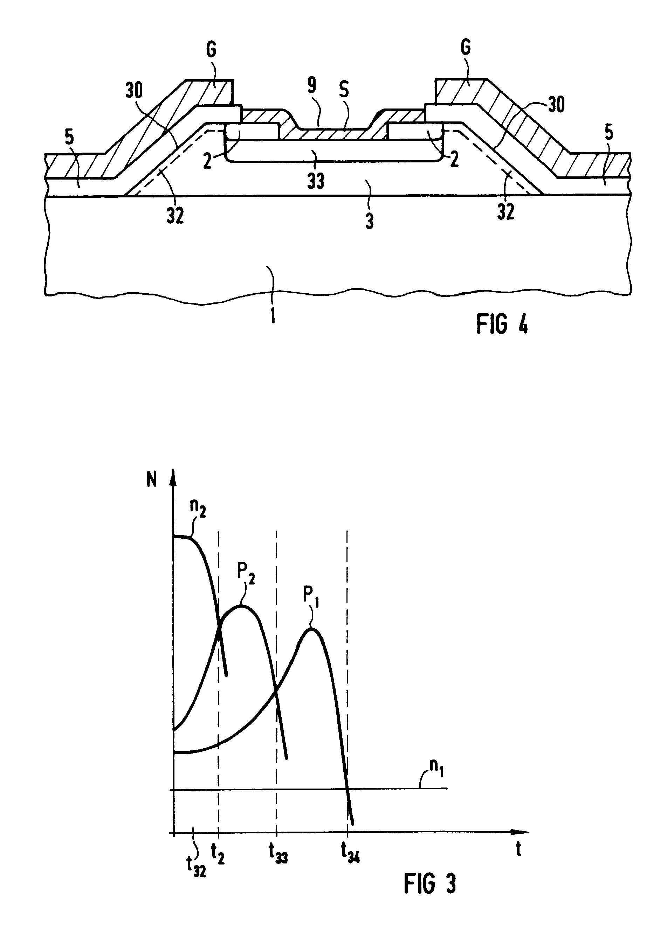

In der FIG. 3 ist ein Ausführungsbeispiel für die Dotierprofile bei einer solchen dreifach implantierten MIS-Struktur in einer Ausführungsform gemäß FIG. 2 gezeigt. Es ist die Teilchenzahl N der Dotierstoffatome pro cm³ über der von der Oberfläche 10 des Driftgebietes 1 aus gemessenen Tiefe t entlang eines durch Sourcegebiet 2, Basisgebiet 3 und Driftgebiet 1 verlaufenden Schnittes senkrecht zur Oberfläche 10 und damit zur Oberfläche 20 aufgetragen.

Die n-Grunddotierung des Driftgebietes 1 ist mit n₁ bezeichnet und ist über die gesamte Tiefe t im wesentlichen konstant. Die beim ersten Implantationsschritt eingebrachte p-Dotierung für das Basisgebiet 3 ist mit p₁ bezeichnet. Die Dotierung p₁ = p₁(t) in Abhängigkeit von der Tiefe t ist durch ein Maximum (Peak) zwischen einer Tiefe t = t₃₃ und einer Tiefe t = t₃₄ und einen flachen Verlauf an der Oberfläche zwischen t = 0 und einer Tiefe t = t₃₂ gekennzeichnet. Zwischen t = t₃₂ und dem Maximum steigt die Dotierung p₁(t) kontinuierlich an und fällt zwischen dem Maximum und der Tiefe t₃₄ vergleichsweise rasch ab. Bei der Tiefe t = t₃₄ unterschreitet die Dotierung p₁(t) die Grunddotierung n₁ des Driftgebietes 1. Die Tiefe t₃₄ definiert somit die Grenze des Basisgebietes 3 zum Driftgebiet 1. Durch einen Tiefenbereich um das Maximum der Dotierung p₁(t) ist das höher dotierte P⁺-Übergangsgebiet 34 des Basisgebietes 3 definiert. Es wird jedoch darauf hingewiesen, daß die in den Figuren dargestellten Begrenzungen des Übergangsgebietes 34 oder auch des Teilgebietes 33 des Basisgebietes 3 nur ungefähre Grenzen darstellen. Die bei einem zweiten Implantationsschritt eingebrachte, weitere p-Dotierung für das Basisgebiet 3 ist mit p₂ bezeichnet. Als Funktion p₂(t) der Tiefe t zeigt diese Dotierung p₂ ein ausgeprägtes Maximum zwischen einer Tiefe t = t₂ und der Tiefe t₃₃. Bei der Tiefe t = t₃₃ stimmen die Dotierungen p₁ und p₂ überein, d.h. p₁(t₃₃) = p₂(t₃₃), und bei größeren Tiefen t > t₃₃ liegt die zweite Dotierung p₂ deutlich unter der ersten Dotierung p₁. Für das Sourcegebiet 2 wird in einem dritten Implantationsschritt eine mit n₂ bezeichnete n-Dotierung eingebracht. Diese dritte Dotierung n₂(t) ist in einem Tiefenbereich zwischen t = 0 und t = t₂ größer als die Summe der beiden p-Dotierungen p₁ und p₂, ist bei der Tiefe t = t₂ nur noch gleich der Dotierung p₂, d.h. n₂(t₂) = p₂(t₂), und nimmt für größere Tiefen t > t₂ weiter ab. Damit ergibt sich ein hochdotiertes n⁺-Sourcegebiet 2 der Tiefe t₂.

Bei einem in der FIG. 2 nicht dargestellten, senkrecht zur Oberfläche 30 des Basisgebietes 3 durch das Kanalgebiet verlaufenden Schnitt ergibt sich in dieser Ausführungsform ein Dotierungsprofil, das sich aus der Grunddotierung n₁ des Driftgebietes 2 und ferner nur noch der ersten p-Dotierung p₁ zusammensetzt. Im Kanalgebiet 32 ist die Dotierung durch die vorzugweise weitgehend konstante Dotierung p₁ bestimmt, die für 0 ≤ t ≤ t₃₂ vorzugsweise deutlich größer als die Grunddotierung n₁ eingestellt ist. Die einzustellende Tiefe t₃₂ des Kanalgebiets 32 ist dabei abhängig von der an der Gateelektrode G angelegten Gatespannung, der Dicke des Isolatorgebiets 5 und der Größe der Dotierung p₁.

Die maximale Höhe der einzelnen Dotierungen n₁, n₂, p₁ und p₂ richtet sich nach den gewünschten Eigenschaften der MIS-Struktur. Im allgemeinen wird das Maximum der Dotierung n₂ für das Sourcegebiet 2 größer gewählt als die beiden Maxima der beiden p-Dotierungen p₁ und p₂ für das Basisgebiet 3. Vorzugsweise wird auch das Maximum der ersten p-Dotierung p₁ für das Übergangsgebiet 34 niedriger gewählt als das Maximum der zweiten p-Dotierung p₂ für das Teilgebiet 33 des Basisgebietes 3. Typische Werte der maximalen Dotierung sind für die n-Dotierung n₂ zwischen 10¹⁸ cm⁻³ und 10²¹ cm⁻³, für die erste p-Dotierung p₁ zwischen 10¹⁶ cm⁻³ und 10¹⁸ cm⁻³ und die zweite p-Dotierung p₂ zwischen 10¹⁷ cm⁻³ und 10¹⁹ cm⁻³. Die Grunddotierung n₁ wird im allgemeinen zwischen 10¹³ cm⁻³ und 5.10¹⁶ cm⁻³ eingestellt. Die Tiefe t₃₂ des Kanalgebietes 32 beträgt im allgemeinen zwischen 0,1 und 1 µm, die Tiefe t₂ des Sourcegebietes 2 im allgemeinen um 0,5 um, die Tiefe t₃₃ des Teilgebietes 33 im allgemeinen zwischen 0,5 µm und 1 µm und die Tiefe t₃₄ des Übergangsgebietes 34 im allgemeinen zwischen 1 µm und 3 µm. Es können allerdings auch kleinere oder größere Tiefen eingestellt werden.

Die Energien für die Ionenimplantationen werden vorzugsweise zwischen 300 keV und 2 MeV eingestellt.

Die Ionenimplantation ist ein besonders geeignetes Vefahren zum Dotieren von SiC, da Diffusionsprozesse in SiC praktisch nicht möglich sind.

Das Basisgebiet 3 kann in einer weiteren Ausführungsform auch epitaktisch auf dem Driftgebiet 1 aufgewachsen sein. Eine solche Ausführungsform ist in FIG. 4 dargestellt. In das epitaktisch aufgewachsene Basisgebiet 3 sind durch Ionenimplantation ein Sourcegebiet 2 und ein darunterliegendes Teilgebiet 33 eingebracht. Das Sourcegebiet 2 ist vorzugsweise zusammenhängend, in seinem inneren Bereich ist jedoch durch einen Ätzprozeß ein bis zum Teilgebiet 33 des Basisgebietes 3 hinunterreichendes Kontaktloch 9 erzeugt. Vorzugsweise ist das Sourcegebiet 2 als rotationssymmetrischer Ring ausgebildet. Das Sourcegebiet 2 und das Teilgebiet 33 des Basisgebietes 3 sind über eine sich von der Oberfläche des Sourcegebietes 2 vorzugsweise durch das ganze Kontaktloch 9 sich erstreckende Sourceelektrode S elektrisch miteinander kontaktiert. Da sich das hoch dotierte Teilgebiet 33 des Basisgebietes 3 bis zur Sourceelektrode S erstreckt, weist diese Ausführungsform einer MIS-Struktur wegen des besonders niedrigen Bahnwiderstandes des Basisgebietes 3 eine besonders hohe Latch-up-Festigkeit auf. Vorzugsweise ist das Basisgebiet 3 rings um das Sourcegebiet 2 so strukturiert, daß seine Oberfläche 30 dort wenigstens teilweise schräg bis zum Driftgebiet 1 verläuft. Auf der Oberfläche 30 des Basisgebietes 3 ist eine aus Isolatorgebiet 5 und Gateelektrode G gebildete Gatestruktur angeordnet. Das durch die Gateelektrode G steuerbare Kanalgebiet 32 unter diesem Bereich der Oberfläche 30 verläuft dann ebenfalls wenigstens teilweise schräg. Die Länge des Kanalgebiets 32 hängt somit auch von der Dicke der das Basisgebiet 3 bildenden Epitaxieschicht ab.

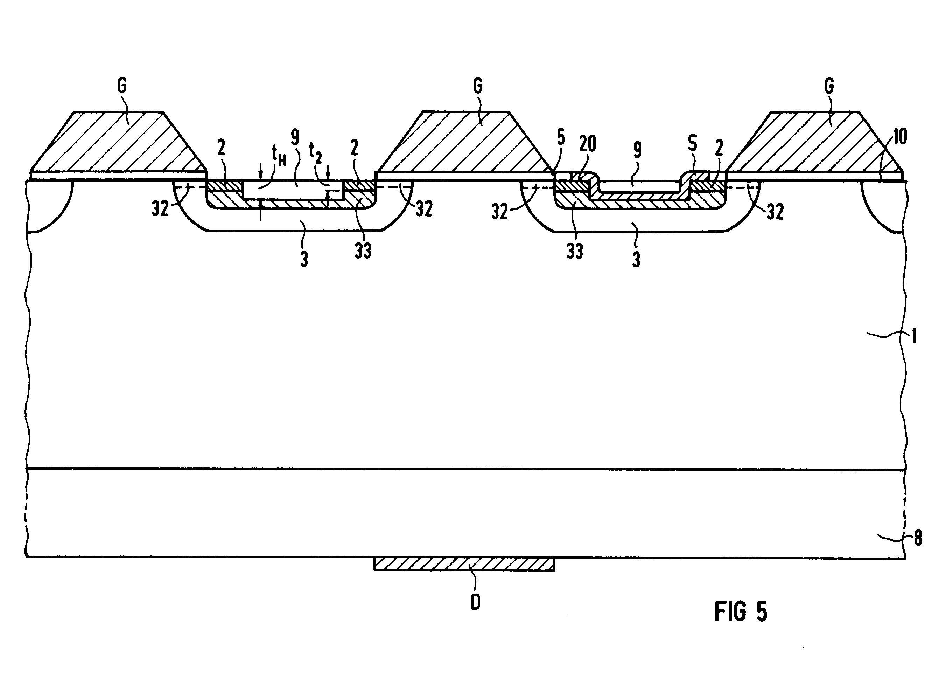

Die FIG. 5 zeigt eine zu einem MISFET oder einem IGBT weitergebildete Ausführungsform einer MIS-Struktur. Es sind an einer Oberfläche 10 eines Driftgebietes 1 vorzugsweise mehrere Basisgebiete 3 mit darin implantierten Sourcegebieten 2 angeordnet, von denen in FIG. 5 nur zwei dargestellt sind. Unterhalb jedes Sourcegebietes 2 ist ein höher dotiertes Teilgebiet 33 des Basisgebietes 3 angeordnet. Innerhalb jedes Sourcegebietes 2 ist ein Kontaktloch 9 erzeugt, das bis zum Teilgebiet 33 hinunterreicht. Vorzugsweise ist die Tiefe t_{H} des Kontaktloches 9 größer als die Tiefe t₂ des Sourcegebietes 2. Die im Kontaktloch 9 freigelegte Oberfläche des Teilgebietes 33 des Basisgebietes 3 ist über eine Sourceelektrode S mit der Oberfläche 20 des Sourcegebietes 2 kontaktiert. Die Sourceelektrode S ist der besseren Übersichtlichkeit halber nur bei dem rechts liegenden Sourcegebiet 2 dargestellt.

Anstelle eines einzigen zusammenhängenden Sourcegebietes 2 können in jedem Basisgebiet 3 auch jeweils zwei vorzugsweise streifenförmige Sourcegebiete 2 vorgesehen sein, die dann vorzugsweise durch das Kontaktloch 9 voneinander getrennt sind. Auf einem Sourcegebiet 2 und Driftgebiet 1 jeweils verbindenden Kanalgebiet 32, das bei einem zusammenhängenden, ringförmigen Sourcegebiet 2 vorzugsweise ebenfalls ein zusammenhängendes Gebiet rings um das Sourcegebiet 2 ist, ist über ein Isolatorgebiet 5 jeweils eine Gateelektrode G angeordnet zum Steuern des Kanalgebiets 32 in seinem elektrischen Widerstand. Zwei unmittelbar benachbarten Basisgebieten 3 ist dabei vorzugsweise eine gemeinsame Gateelektrode G zugeordnet. Das Driftgebiet 1 ist vorzugsweise als epitaktisch aufgewachsene Schicht auf einem Substrat 8 angeordnet. Das Substrat 8 ist mit einem und vorzugsweise demselben Halbleitermaterial wie das Driftgebiet 1 gebildet und vorzugsweise höher dotiert als das Driftgebiet 1.

An einer vom Driftgebiet 1 abgewandten Oberfläche des Substrats 8 ist eine Drainelektrode D angeordnet. Zwischen dieser Drainelektrode D und den Sourceelektroden S wird die Betriebsspannung für das MIS-Bauelement angelegt. Ein solcher vertikaler Aufbau mit einem im Betrieb im wesentlichen vertikal durch das Driftgebiet 1 und das Substrat 8 fließenden Strom ist besonders für eine Anwendung in der Leistungselektronik mit hohen Strömen und Spannungen geeignet.

In einer als MISFET vorgesehenen Ausführungsform dieser MIS-Struktur ist das Substrat 8 vom gleichen Leitungstyp wie das Driftgebiet 1 gewählt, also n-leitend bei n-leitendem Driftgebiet 1 und p-leitend bei p-leitendem Driftgebiet 1.

In einer als IGBT vorgesehenen Ausführungsform der MIS-Struktur ist das Substrat 8 hingegen vom entgegengesetzten Leitungstyp wie das Driftgebiet 1 gewählt, also p-leitend bei n-leitendem Driftgebiet 1 und n-leitend bei p-leitendem Driftgebiet 1. Zwischen der dann als Kollektor des IGBT vorgesehenen Drainelektrode D und den als Emitter des IGBT vorgesehenen Sourceelektroden S sind bei diesem IGBT drei statt nur zwei p-n-Übergänge wie beim MISFET angeordnet. Dadurch tragen zum Stromtransport im Durchlaßfall beide Ladungsträgertypen, also Löcher und Elektronen, bei (bipolares Bauelement).

In einer nicht dargestellten, weiteren Ausführungsform einer MIS-Struktur kann als Driftgebiet 1 ein Halbleitersubstrat vorgesehen sein. Eine Drainelektrode kann in diesem Fall auch an einer von der Oberfläche des Driftgebietes mit Basisgebiet und Sourcegebiet abgewandten Oberfläche des Driftgebietes angeordnet sein.

Die Drainelektrode kann in einer weiteren, ebenfalls nicht dargestellten Ausführungsform einer MIS-Struktur auch an derselben Oberfläche des Driftgebietes wie die Sourceelektrode angeordnet sein. Man erhält so einen lateralen Aufbau mit lateral zueinander versetzten Source und Drain.

Schließlich ist in einer vorteilhaften Ausführungsform das mit der Drainelektrode kontaktierte Halbleitergebiet, sei es das Driftgebiet 1 oder das Substrat 8, wenigstens in einem Draingebiet unter dieser Drainelektrode höher dotiert. Dieses Draingebiet ist vorzugsweise ebenfalls durch Ionenimplantation von entsprechenden Donator- oder Akzeptoratomen erzeugt. Durch eine entsprechende Wahl des Leitungstyps des Draingebiets kann man wieder entweder einen lateralen oder vertikalen MISFET oder IGBT erhalten.

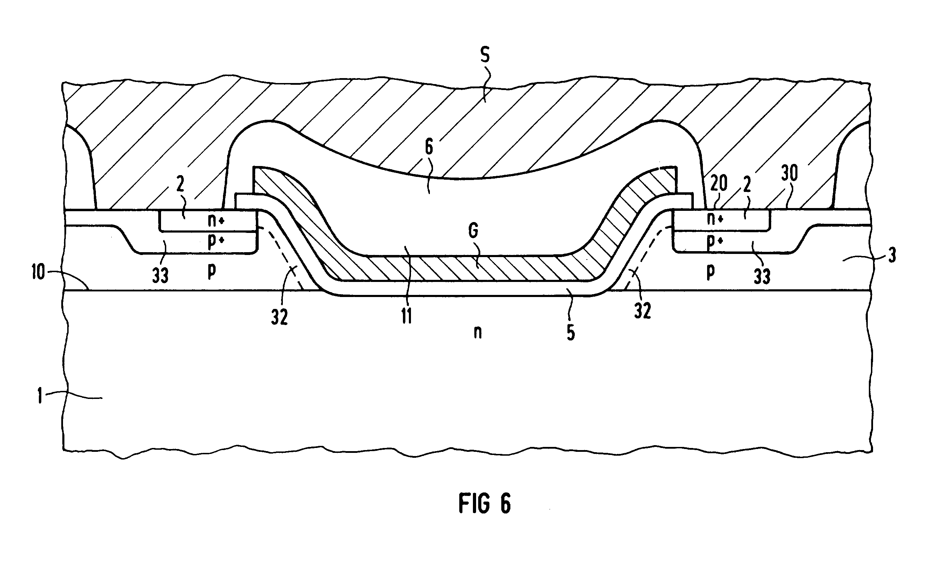

In FIG. 6 ist nun eine Ausführungsform einer Trench-MIS-Struktur gezeigt. Auf der Oberfläche 10 des n-dotierten Driftgebiets 1 ist das p-dotierte Basisgebiet 3 angeordnet. Das Driftgebiet 1 ist vorzugsweise wieder eine Epitaxieschicht. Das Basisgebiet 3 ist vorzugsweise epitaktisch auf dem Driftgebiet 1 aufgewachsen, kann aber auch durch Ionenimplantation erzeugt sein. In dem Basisgebiet 3 ist wenigstens ein Sourcegebiet 2 implantiet. Das höher dotierte Teilgebiet 33 des Basisgebiets 3 unter dem Sourcegebiet 2 erstreckt sich vorzugsweise bis zur Oberfläche 30 des Basisgebiets 3 neben dem Sourcegebiet 2. Durch das Basisgebiet 3 ist eine Ausnehmung 11 beispielsweise durch Ionenätzen erzeugt, die bis hinunter in das Driftgebiet 1 reicht. Auf der Oberfläche dieser Ausnehmung 11 ist eine Isolatorschicht als Isolatorgebiet 5 angeordnet, vorzugsweise eine dünne thermische Oxidschicht, die bis zum Sourcegebiet 2 reicht. Auf dem Isolatorgebiet 5 ist die Gateelektrode G angeordnet, die beispielsweise aus Metall oder Polysilicium besteht. Die Gateelektrode G ist nun mit einer weiteren Isolatorschicht 6 überzogen (buried-gate). In dieser Isolatorschicht 6 sind im Bereich des Sourcegebiets 2 Fenster erzeugt. Durch diese Fenster sind das Sourcegebiet 2 und das Teilgebiet 33 des Basisgebiets 3 über die auf der Isolatorschicht 6 abgeschiedene Sourceelektrode S kontaktiert. Das Kanalgebiet 32 des Basisgebiets 3 verläuft entlang der seitlichen Wände der Ausnehmung 11. Die Ausnehmung 11 kann insbesondere V-förmig oder U-förmig sein.

Anders als in den bisher beschriebenen Ausführungsformen der MIS-Struktur kann sich das höher dotierte Teilgebiet 33 des Basisgebietes 3 auch nur unter einem Teil des Sourcegebietes 2 erstrecken. Die Latch-up-Festigkeit wird auch bei einem nur teilweise unterhalb des Sourcegebietes 2 angeordneten höherdotierten Teilgebiet 33 des Basisgebiets 3 erhöht. Die Dimensionierung des Teilgebiets 33 wird dann der erforderlichen Latch-up-Festigkeit angepaßt.

Bei allen Ausführungsformen können die Leitungstypen der einzelnen Halbleitergebiete der MIS-Struktur vertauscht werden, d.h. statt der n-dotierten Gebiete p-dotierte Gebiete und gleichzeitig statt der p-dotierten Gebiete n-dotierte Gebiete vorgesehen werden. Der Typ der Dotierung ist dann insbesondere auch bei den einzelnen Dotierschritten durch Ionenimplantation gerade komplementär zu den beschriebenen Ausführungsformen zu wählen.

Als Dotierstoffe kommen prinzipiell alle für Siliciumcarbid (SiC) geeigneten Akzeptor- oder Donatormaterialien in Frage, beispielsweise zur p-Dotierung Bor (B) oder Aluminium (Al) und zur n-Dotierung Stickstoff (N).

Für die Gateelektrode G und das Isolatorgebiet 5 kommen prinzipiell alle gängigen Materialien in Frage. Vorzugsweise wird jedoch als Isolatormaterial für das Isolatorgebiet 5 Siliciumdioxid (SiO₂) gewählt, das vorzugsweise durch thermische Oxidation oder auch durch einen CVD-Prozeß aufgebracht werden kann.

Das p⁺-Teilgebiet 33 des Basisgebietes 3 unter dem Sourcegebiet 2 ist in einer besonders vorteilhaften Ausführungsform mit Aluminium (Al) dotiert. Die Aluminiumdotierung dieses Teilgebiets 33 des Basisgebiets 3 sichert über einen weiten Temperaturbereich einen geringen lateralen Bahnwiderstand des Basisgebiets 3 unter dem Sourcegebiet 2. Aluminium hat in SiC ein flacheres Akzeptorniveau als Bor und ist stärker ionisiert. Mit Aluminium als Akzeptor kann eine etwa 10 mal höhere Leitfähigkeit in SiC erreicht werden als mit Bor. In den Ausführungsformen, in denen das höher dotierte Teilgebiet 33 des Basisgebietes 3 sich bis zur Sourceelektrode S erstreckt, wird mit der Aluminiumdotierung auch ein besonders guter Kontakt zwischen Basisgebiet 3 und Sourceelektrode S hergestellt.

Das Kanalgebiet 32 des Basisgebiets 3 wird mit Bor (B) p-dotiert. Die Dotierung ist dabei deutlich geringer als im Teilgebiet 33. Mit der niedrigen Bordotierung im Kanalgebiet 32 erreicht man eine niedrige Schwellspannung der MIS-Struktur. Ein besonderer Vorteil von Bor als Dotierstoff für das Kanalgebiet 32 ist seine chemische Verträglichkeit mit einem insbesondere thermisch erzeugten Oxid für das Isolatorgebiet 5, so daß keine chemischen Reaktionen mit dem Oxid stattfinden. In den Ausführungsformen mit dem höher dotierten Übergangsgebiet 34 des Basisgebiets 3 wird auch das Übergangsgebiet 34 vorzugsweise mit Bor dotiert. Die in SiC tiefen Akzeptorniveaus des Bor werden in dem Übergangsgebiet 34 im Sperrfall vollständig ionisiert und gewährleisten die hohe Sperrfähigkeit der MIS-Struktur.

Das Sourcegebiet 2 ist nun vorzugsweise mit Stickstoff (N) dotiert. Die vorzugsweise weitgehend homogene und hohe Stickstoffdotierung für das Sourcegebiet 2 ermöglicht einen niedrigen Source-Kontaktwiderstand, der unter 10⁻⁴ Ω cm² liegen kann, und zugleich einen niedrigen Sourcebahnwiderstand in SiC.

Die Dotierung des Basisgebiets 3 mit Bor, des Teilgebiets 33 des Basisgebiets 3 mit Aluminium und des Sourcegebiets 2 mit Stickstoff wird in einer besonders vorteilhaften Ausführungsform durch Dreifachimplantation mit vorzugsweise gemäß FIG. 3 eingestellten Dotierprofilen erzeugt. Die in FIG. 3 mit n₂ bezeichnete Dotierung entspricht dann der Stickstoffdotierung, die mit p₁ bezeichnete Dotierung der Bordotierung und die mit p₂ bezeichnete Dotierung der Aluminiumdotierung.

## Patentansprüche

1. Metall-Isolator-Halbleiter (MIS)-Struktur mit
a) wenigstens einem Driftgebiet (1),
b) wenigstens einem an oder in einer Oberfläche (10) des Driftgebietes (1) angeordneten Basisgebiet (3),
c) wenigstens einem Sourcegebiet (2), das durch das Basisgebiet (3) vom Driftgebiet (1) getrennt ist,
d) wenigstens einer Sourceelektrode (S), über die das Sourcegebiet (2) und das Basisgebiet (3) elektrisch miteinander kontaktiert sind,
e) wenigstens einem das Sourcegebiet (2) und das Driftgebiet (1) verbindenden Kanalgebiet (32) des Basisgebietes (3) und
f) wenigstens einer Gateelektrode (G) zum Steuern des elektrischen Widerstandes des Kanalgebietes (32) über ein zwischen Kanalgebiet (32) und Gatelektrode (G) angeordnetes und mit einem Oxid gebildetes Isolatorgebiet (5), wobei
g) das Driftgebiet (1) und das Sourcegebiet (2) jeweils mit Siliciumcarbid (SiC) vom n-Leitungstyp gebildet sind,
h) das Basisgebiet (3) mit Siliciumcarbid (SiC) vom p-Leitungstyp gebildet ist und wenigstens im Kanalgebiet (32) mit Bor (B) dotiert ist und wobei
i) in dem Basisgebiet (3) wenigstens ein sich wenigstens teilweise unterhalb des Sourcegebietes (2) erstreckendes und unmittelbar an das Sourcegebiet (2) angrenzendes Teilgebiet (33) vorgesehen ist, das mit Aluminium (Al) dotiert ist und eine höhere Ladungsträgerkonzentration aufweist als das Kanalgebiet (32) des Basisgebietes (3).

2. MIS-Struktur nach Anspruch 1, bei der das genannte Teilgebiet (33) des Basisgebietes (3) sich unterhalb des gesamten Sourcegebietes (2) erstreckt.

3. MIS-Struktur nach Anspruch 1 oder Anspruch 2, bei der das genannte Teilgebiet (33) des Basisgebiets (3) sich bis zur Sourceelektrode (S) erstreckt.

4. MIS-Struktur nach einem der vorhergehenden Ansprüche, bei der das Basisgebiet (3) in einem an das Driftgebiet (1) angrenzenden Übergangsgebiet (34) eine höhere Ladungsträgerkonzentration aufweist als in seinem Kanalgebiet (32).

5. MIS-Struktur nach Anspruch 4, bei der das Übergangsgebiet (34) des Basisgebiets (3) mit Bor (B) dotiert ist.

6. MIS-Struktur nach einem der vorhergehenden Ansprüche, bei der das gesamte Basisgebiet (3) mit Bor (B) dotiert ist.

7. MIS-Struktur nach einem der vorhergehenden Ansprüche, bei der das Sourcegebiet (2) mit Stickstoff (N) dotiert ist.

8. MIS-Struktur nach einem der vorhergehenden Ansprüche, bei der das Driftgebiet (1) an einer von seiner Oberfläche (10) abgewandten Seite auf einem Halbleitersubstrat (8) angeordnet ist.

9. MIS-Struktur nach Anspruch 8, bei der das Halbleitersubstrat (8) eine höhere Ladungsträgerkonzentration aufweist als das Driftgebiet (1).

10. MIS-Struktur nach Anspruch 8 oder Anspruch 9, bei der das Halbleitersubstrat (8) vom entgegengesetzten Leitungstyp ist wie das Driftgebiet (1).

11. MIS-Struktur nach Anspruch 8 oder Anspruch 9, bei der das Halbleitersubstrat (8) vom gleichen Leitungstyp ist wie das Driftgebiet (1).

12. MIS-Struktur nach einem der Ansprüche 8 bis 11, bei der an einer von dem Driftgebiet (1) abgewandten Oberfläche des Halbleitersubstrats (8) eine Drainelektrode (D) angeordnet ist.

13. MIS-Struktur nach einem der vorhergehenden Ansprüche, bei der das Oxid des Isolatorgebiets (5) thermisch erzeugt ist.

## Claims

1. A metal-insulator-semiconductor (MIS) structure comprising
a) at least one drift region (1),
b) at least one base region (3) arranged on or in a surface (10) of the drift region (1),
c) at least one source region (2) which is separated from the drift region (1) by the base region (3),
d) at least one source electrode (S) via which the source region (2) and the base region (3) are electrically contacted with one another,
e) at least one channel region (32) of the base region (3) connecting the source region (2) and drift region (1) and
f) at least one gate electrode (G) for controlling the electrical resistance of the channel region (32) via an insulating region (5) formed from an oxide and arranged between the channel region (32) and the gate electrode (G), wherein
g) the drift region (1) and the source region (2) are in each case formed from silicon carbide (SiC) of the n-conductivity type,
h) the base region (3) is formed from silicon carbide (SiC) of the p-conductivity type and is doped with boron (B) at least in the channel region (32) and wherein
i) in the base region (3) there is provided at least one sub-region (33) which extends at least partially beneath the source region (2) and directly adjoins the source region (2) and which is doped with aluminium (Al) and has a higher charge carrier concentration than the channel region (32) of the base region (3).

2. A MIS structure according to Claim 1, wherein the said sub-region (33) of the base region (3) extends beneath the whole of the source region (2).

3. A MIS structure according to Claim 1 or Claim 2, wherein the said sub-region (33) of the base region (3) extends up to the source electrode (S).

4. A MIS structure according to one of the preceding claims, wherein the base region (3) has a higher charge carrier concentration in a junction region (34) adjoining the drift region (1) than in its channel region (32).

5. A MIS structure according to Claim 4, wherein the junction region (34) of the base region (3) is doped with boron (B).

6. A MIS structure according to one of the preceding claims, wherein the entire base region (3) is doped with boron (B).

7. A MIS structure according to one of the preceding claims, wherein the source region (2) is doped with nitrogen (N).

8. A MIS structure according to one of the preceding claims, wherein the drift region (1) is arranged on a semiconductor substrate (8) on a side facing away from its surface (10).

9. A MIS structure according to Claim 8, wherein the semiconductor substrate (8) has a higher charge carrier concentration than the drift region (1).

10. A MIS structure according to Claim 8 or Claim 9, wherein the semiconductor substrate (8) is of the opposite conductivity type to the drift region (1).

11. A MIS structure according to Claim 8 or Claim 9, wherein the semiconductor (8) substrate is of the same conductivity type to the drift region (1).

12. A MIS structure according to one of Claims 8 to 11, wherein a drain electrode (D) is arranged on a surface of the semiconductor substrate (8) facing away from the drift region (1).

13. A MIS structure according to one of the preceding claims, wherein the oxide of the insulating region (5) is thermally produced.

## Revendications

1. Structure à métal-isolant-semi-conducteur (MIS) comportant
a) au moins une zone (1) de migration,
b) au moins une zone (3) de base disposée sur ou dans une surface (10) de la zone (1) de migration,
c) au moins une zone (2) de source, qui est séparée de la zone (1) de migration par la zone (3) de base,
d) au moins une électrode (S) de source, par l'intermédiaire de laquelle la zone (2) de source et la zone (3) de base sont mises en contact électrique l'une avec l'autre,
e) au moins une zone (32) de canal de la zone (3) de base reliant la zone (2) de source et la zone (1) de migration,
et
f) au moins une électrode (G) de grille pour commander la résistance électrique de la zone (32) de canal par l'intermédiaire d'une zone (5) isolante disposée entre la zone (32) de canal et l'électrode (G) de grille et formée par un oxyde,
g) la zone (1) de migration et la zone (2) de source étant formées chacune par du carbure de silicium (SiC) du type de conductivité n,
h) la zone (3) de base étant formée par du carbure de silicium (SiC) du type de conductivité p et étant dopée par du bore (B) au moins dans la zone (32) de canal, et
i) au moins une zone (33) partielle, qui s'étend au moins partiellement au dessous de la zone (2) de source, qui est directement adjacente à la zone (2) de source, qui est dopée par de l'aluminium (Al) et qui a une concentration de porteur de charge plus grande que la zone (32) de canal de la zone (3) de base, étant prévue dans la zone (3) de base.

2. Structure MIS suivant la revendication 1, dans laquelle ladite zone (33) partielle de la zone (3) de base s'étend au dessous de toute la zone (2) de source.

3. Structure MIS suivant la revendication 1 ou suivant la revendication 2, dans laquelle ladite zone (33) partielle de la zone (3) de base s'étend jusqu'à l'électrode (S) de source.

4. Structure MIS suivant l'une des revendications précédentes, dans laquelle la zone (3) de base a, dans une zone (34) de transition adjacente à la zone (1) de migration, une concentration de porteurs de charge plus grande que dans sa zone (32) de canal.

5. Structure MIS suivant la revendication 4, dans laquelle la zone (34) de transition de la zone (3) de base est dopée par du bore (B).

6. Structure MIS suivant l'une des revendications précédentes, dans laquelle toute la zone (3) de base est dopée par du bore (B).

7. Structure MIS suivant l'une des revendications précédentes, dans laquelle la zone (2) de source est dopée par de l'azote (N).

8. Structure MIS suivant l'une des revendications précédentes, dans laquelle la zone (1) de migration est disposée sur un substrat (8) semi-conducteur sur un côté éloigné de sa surface (10).

9. Structure MIS suivant la revendication 8, dans laquelle le substrat (8) semi-conducteur a une concentration de porteurs de charge plus grande que la zone (1) de migration.

10. Structure MIS suivant la revendication 8 ou suivant la revendication 9, dans laquelle le substrat (8) semi-conducteur est du même type de conductivité la zone (1) de migration.

11. Structure MIS suivant la revendication 8 ou suivant la revendication 9, dans laquelle le substrat (8) semi-conducteur est du même type de conductivité que la zone (1) de migration.

12. Structure MIS suivant l'une des revendications 8 à 11, dans laquelle une électrode (D) de drain est disposée sur une surface du substrat (8) semi-conducteur éloignée de la zone (1) de migration.

13. Structure MIS suivant l'une des revendications précédentes, dans laquelle l'oxyde de la zone (5) isolante est produit de manière thermique.
